# EUROPEAN PATENT APPLICATION

(11) **EP 3 364 473 A1**
(43) Date of publication of application: **22.08.2018**
(21) Application number: 16855312.1
(22) Date of filing: 04.10.2016
(51) Int. Cl.: H01L 51/44, H01B 1/22

(54) **ORGANIC PHOTOELECTRIC CONVERSION ELEMENT**

(30) Priority: 16.10.2015 JP 2015204543
(71) Applicant: SUMITOMO CHEMICAL COMPANY, LIMITED, Chuo-ku Tokyo 104-8260 (JP)
(72) Inventor: FERRARA, Giovanni, Tsukuba-shi Ibaraki 300-3294 (JP); SEIKE, Takahiro, Tsukuba-shi Ibaraki 300-3294 (JP)
(74) Representative: Vossius & Partner Patentanwälte Rechtsanwälte mbB
(86) International application number: PCT/JP2016/079474
(87) International publication number: WO 2017/065058

(57) **Abstract**

Provided is an organic photoelectric conversion element having improved durability. An organic photoelectric conversion element (10) comprises a layered structure (20) comprising a pair of electrodes (40) comprising a first electrode (42) and a second electrode (44), and an active layer (50) provided between the pair of electrodes, wherein at least one electrode of the pair of electrodes comprise an electrode containing a getter material (46) comprising an conductive material layer (46a) having interstitial spaces (46aa) which a first harmful substance contained in the layered structure permeates and at least one kind of the getter material (46b) which is capable of reacting with the first harmful substance, and the getter material is contained at least a part of the interstitial spaces.

## Description

### TECHNICAL FIELD

The present invention relates to an organic photoelectric conversion element and a method for manufacturing the same.

### BACKGROUND ART

Organic photoelectric conversion elements have emerged as new organic-based technologies with a potentiality for a variety of applications including photodetectors and the like, not only energy conversion.

As one common approach to prevent deterioration of the organic photoelectric conversion element caused by water and oxygen, it is disclosed to provide a getter sheet placed in the interior side of the cover glass for encapsulation (Refer to Patent Document 1).

### RELATED ART DOCUMENTS

Patent Document 1: JP 2009-099805 A

### DISCLOSURE OF INVENTION

### PROBLEM TO BE SOLVED BY THE INVENTION

However, the durability of the organic photoelectric conversion element described in the Patent Document 1 is not sufficient.

### MEANS FOR SOLVING PROBLEM

The present invention was made for solving the above problem. The present invention provides [1] to [16] below.
[1] An organic photoelectric conversion element comprising:
   a layered structure comprising a pair of electrodes comprising a first electrode and a second electrode; and
   an active layer provided between the pair of electrodes,
      wherein,
   at least one electrode of the pair of electrodes comprises an electrode containing a getter material comprising an conductive material layer having interstitial spaces which a first harmful substance contained in the layered structure permeates and at least one kind of the getter material which is capable of reacting with the first harmful substance, and
   the getter material is contained in at least a part of the interstitial spaces.
[2] The organic photoelectric conversion element according to above [1], wherein the getter material is a material further reacting with a second harmful substance out of the layered structure.
[3] The organic photoelectric conversion element according to above [1] or [2], wherein the getter material is distributed in the conductive material layer, and placed in the interstitial spaces.
[4] The organic photoelectric conversion element according to any one of above [1] to [3], wherein the surface of the electrode containing the getter material is covered with the getter material.
[5] The organic photoelectric conversion element according to any one of above [1] to [4], further comprising an interlayer provided between the electrode containing the getter material and the active layer.
[6] The organic photoelectric conversion element according to any one of above [1] to [5], wherein the getter material is a material reacting with the first harmful substance, or a combination of the first harmful substance and the second harmful substance to form a harmless substance.
[7] The organic photoelectric conversion element according to above [6], wherein the getter material comprises one or more materials selected from the group consisting of Ca, Al, Ti, Ba, Zr, Mg, Si, C, In, V, Nb and Ta.
[8] The organic photoelectric conversion element according to above [6], wherein the getter material comprises an organic metal compound containing one or more metallic elements selected from the group consisting of Ca, Al, Ti, Ba, Zr, Mg, Si, In, V, Nb and Ta.
[9] The organic photoelectric conversion element according to above [8], wherein the organic metal compound is a metal alkoxide.
[10] The organic photoelectric conversion element according to above [9], wherein the metal alkoxide contains one or more metallic elements selected from the group consisting of Ca, Al, Ti, Ba, Zr, Mg, Si and In.
[11] The organic photoelectric conversion element according to above [6], wherein the getter material is a material reacting with the first harmful substance or the combination of the first harmful substance and the second harmful substance to form a substance enhancing a light transmittance of the electrode containing the getter material.
[12] The organic photoelectric conversion element according to above [11], wherein the getter material comprises Ca.
[13] The organic photoelectric conversion element according to any one of above [1] to [12], wherein the conductive material layer has porous structure or mesh structure containing nanoparticles or nanowires as a conductive material.
[14] The organic photoelectric conversion element according to above [13], wherein the nanowires are metallic nanowires.
[15] A method for manufacturing the organic photoelectric conversion element according to any one of above [1] to [14] comprising:
   a step of forming the conductive material layer having interstitial spaces; and
   a step of forming the electrode containing the getter material by applying the getter material which is capable of reacting with the first harmful substance in at least a part of interstitial spaces of the conductive material layer.
[16] The method for manufacturing the organic photoelectric conversion element according to above [15], wherein the step of forming the electrode containing the getter material is a step of applying the getter material in the interstitial spaces by an evaporating method or an coating method.

### EFFECT OF THE INVENTION

According to the present invention, an organic photoelectric conversion element having excellent durability characteristics is achieved.

### BRIEF DESCRIPTION OF DRAWINGS

Fig. 1 is a schematic cross-sectional view of the organic photoelectric conversion element of the present invention.
Fig. 2 is a schematic cross-sectional view of the element layered structure of the embodiment 1.
Fig. 3 is a schematic cross-sectional view of the element layered structure of the embodiment 2.
Fig. 4A is a SEM image of the electrode containing the getter material of Example 1.
Fig. 4B is a SEM image of the electrode containing the getter material of Comparative Example 2.
Fig. 5 is a graph illustrating the light transmittance of the organic photoelectric conversion element.

### DESCRIPTION OF EMBODIMENTS

Hereinafter, embodiments of the present invention are described in detail with reference to the drawing. Each drawing only schematically illustrates shapes, sizes, and locations of constituents in such a degree that the present invention can be understood. Therefore, the present invention is not particularly limited by this description, and each constituent can be modified within a range without departing from the scope of the present invention. In each drawing used for the following description, the same reference numerals may be assigned to the same constituents and overlapped description may be omitted.

### <Constitution of the organic photoelectric conversion element>

The organic photoelectric conversion element of the present invention comprises a layered structure comprising a pair of electrodes comprising a first electrode and a second electrode, and an active layer provided between the pair of electrodes, wherein at least one electrode of the pair of electrodes comprises an electrode containing a getter material comprising an conductive material layer having interstitial spaces which a first harmful substance contained in the layered structure permeates and at least one kind of the getter material which is capable of reacting with the first harmful substance, and the getter material is contained in at least a part of the interstitial spaces.

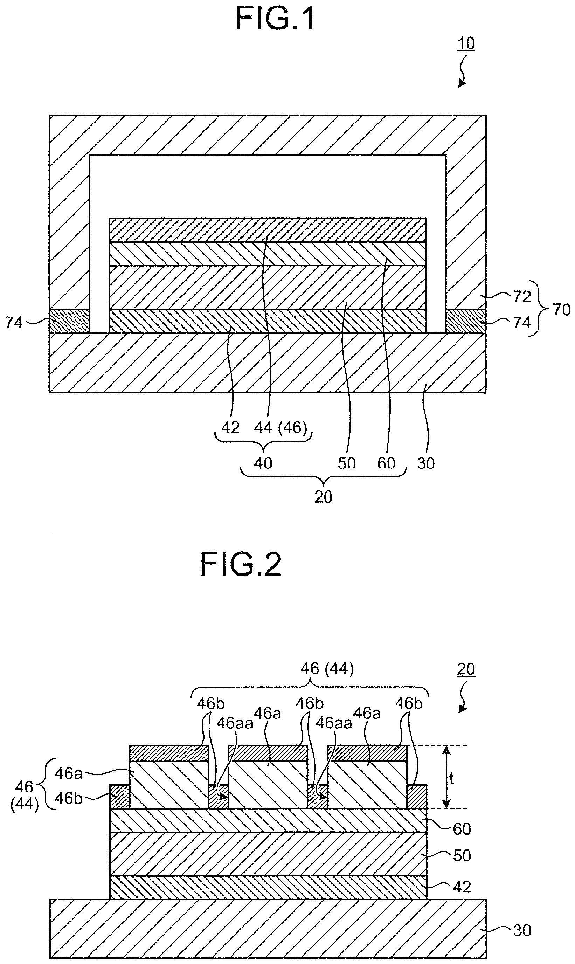

With reference to Figs. 1 and 2, an example of constitution of the organic photoelectric conversion element will be described. Fig. 1 is a schematic cross-sectional view of the organic photoelectric conversion element of the present invention. Fig. 2 is a schematic cross-sectional view of the element layered structure of the embodiment 1.

As illustrated in Fig. 1, the organic photoelectric conversion element 10 of the present invention comprises a substrate 30. The element layered structure (layered structure) 20 is provided on the substrate 30. In the example of constitution, the element layered structure 20 comprises the pair of electrodes 40 comprising the first electrode 42 and the electrode containing a getter material 46 serving as a second electrode 44, the active layer 50 provided between the pair of electrodes, and the interlayer 60 provided between the active layer 50 and the second electrode 44.

As illustrated in Fig. 2, the electrode containing the getter material 46 comprises the conductive material layer 46a having interstitial spaces 46aa which a first harmful substance between the pair of electrodes 40 permeates and at least one kind of the getter material 46b which is capable of reacting with the first harmful substance. In other words, the first electrode 42 is in contact with the substrate 30. The active layer 50 is in contact with the first electrode 42. In the constitution example, the interlayer 60 is in contact with the active layer 50. The electrode containing the getter material 46 as the second electrode 44 is in contact with the interlayer 60.

In the constitution example, the organic photoelectric conversion element 10 is encapsulated in encapsulation member 70 including the cover glass 72 and the sealant (adhesive) 74. The sealant 74 is provided on the surface of substrate 30 so as to surround the layered structure 20. The cover glass 72 and the surface of substrate 30 are joined by the sealant 74, thereby encapsulating the layered structure 20. The sealant 74 may be provided so as to cover the whole exposed surface of the layered structure.

Each of the constitutions will be described below.

### [Substrate]

As the substrate 30, a substrate not being chemically changed during formation of an electrode is usually used. Examples of materials for the substrate 30 may include a glass, a plastic, a polymer film, a metallic foil, and silicon.

A transparent or translucent substrate is used as the substrate 30. As the substrate 30, an opaque substrate may be used. However, when the opaque substrate is used, the electrode opposite to the opaque substrate (that is, either the first electrode 42 or the second electrode 44 which is the electrode more distant from the opaque substrate) is preferably transparent or translucent.

### [First electrode and Second electrode]

First, the first electrode 42 and second electrode 44 without the electrode containing the getter material 46 is described.

Of the first electrode 42 and the second electrode 44, one is a cathode and the other is an anode. At least one of the first electrode 42 and the second electrode 44 is preferably transparent or translucent so that light can readily enter the active layer 50 provided between the first electrode 42 and the second electrode 44.

Examples of transparent or translucent electrode may include a film made from an electrically conductive metal oxide film and a translucent metal thin film. Examples of materials for transparent or translucent electrode may include indium oxide, zinc oxide, tin oxide, a complex thereof such as indium-tin-oxide (ITO) and indium-zinc-oxide (IZO).

Moreover, as materials for the transparent or translucent electrode, organic materials can be used. Examples of the organic materials usable as materials for the electrode may include a polyaniline or derivatives thereof and a polythiophene or derivatives thereof. Further, carbon nanotubes or derivatives thereof, or a graphite or derivatives thereof can be used.

As the transparent or translucent electrode materials, a metal may be used. Examples of the metal may include silver (Ag), gold (Au), zinc (Zn), indium (In), ruthenium (Ru), gallium (Ga), palladium (Pd), iridium (Ir), and platinum (Pt). Specific examples of the embodiment of the usable metals may include nanowires, grid of meshes, nanoparticles, and thin films, which made of the metals selected from the group consisting of the metals described above.

Examples of materials for the opaque electrode may include a metal and a conductive polymer. Specific examples of the materials for the opaque electrode may include: a metal such as Ag, Au, Zn, In, Ru, Ga, Pd, Ir, Pt, lithium (Li), sodium (Na), potassium (K), rubidium (Rb), cesium (Cs), magnesium (Mg), calcium (Ca), strontium (Sr), barium (Ba), aluminum (Al), scandium (Sc), vanadium (V), yttrium (Y), cerium (Ce), samarium (Sm), europium (Eu), terbium (Tb), and ytterbium (Yb); an alloy of two or more of the metals; an alloy of one or more of the metals and one or more of metals selected from the group consisting of Au, Ag, Pt, copper (Cu), manganese (Mn), titanium (Ti), cobalt (Co), nickel (Ni), tungsten (W), and tin (Sn); graphite; a graphite intercalation compound; graphene and derivatives thereof; carbon nanotube and derivatives thereof; fullerene and derivatives thereof; polyaniline and derivatives thereof; and polythiophene and derivatives thereof. Specific examples of the alloy may include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

The first electrode 42 and the second electrode 44 have a varied thickness depending on the material type thereof. When the electrode is used as the transparent or the translucent electrode, the thickness of the first electrode 42 and the second electrode 44 are preferably 500 nm or smaller and more preferably 200 nm or smaller from the viewpoint of increasing light transparency (light transmittance) and of suppressing electric resistance. The lower limit of the thickness of the first electrode 42 and the second electrode 44 is not limited when the lower limit of the thickness is greater than 0, and the thickness is generally 10 nm or larger. Herein, the term "light transmittance" means the transmittance wherein the wave length is in the range from 300 nm to 1200 nm. The light transmittance is preferably more than 10%, more preferably more than 30%, still more preferably more than 40%, particularly preferably more than 80%.

The first electrode 42 and the second electrode 44 can be formed by various formation methods, considering conditions such as a type of materials and the thickness of layers. When using a coating liquid, a coating method may be used. Examples of the other film formation methods may include a vacuum evaporation method, a sputtering method, and a chemical vapor deposition (CVD) method.

### [Electrode containing the getter material]

At least one of the first electrode 42 and the second electrode 44 is the electrode containing the getter material 46. The electrode containing the getter material 46 may be cathode or anode. The electrode containing the getter material 46 may be transparent, translucent or opaque electrode.

The electrode containing the getter material 46 comprises the conductive material layer 46a having a plurality of interstitial spaces 46aa and at least one kind of the getter material 46b. The conductive material layer 46a having a plurality of interstitial spaces 46aa may be a layer having interstitial spaces wherein the getter material 46b is filled at least in a part of the interstitial spaces.

The getter material 46b may be contained at least in a part of a plurality of the interstitial spaces 46aa and/or contained at least in a part of the interior of the interstitial space 46aa.

The plurality of interstitial spaces 46aa of the conductive material layer 46a (the electrode containing the getter material 46) has a function which the first harmful substance between the pair of electrodes 40 permeates in the thickness direction t of the electrode containing the getter material 46. The shape and the size of the plurality of interstitial spaces 46aa are not limited with the provisos that the electrode containing the getter material 46 can function. The conductive material layer 46a is regularly formed in lattice-shaped, for example, thereby defining the plurality of interstitial spaces 46aa as penetration holes arranged regularly. The interstitial spaces 46aa may be defined by a plurality of fine holes sequentially arranged.

The conductive material layer 46a may comprise porous structure or mesh structure containing nanoparticles or nanowires as the conductive materials. Herein, the porous structure and the mesh structure may be consist of nanoparticles or nanowires. Examples of materials of the nanoparticles and the nanowires as the conductive material may include metals (Ag, Al, Cu, Au and Pt), conductive oxides (zinc oxide, tin oxide and indium oxide), and conductive polymers (polythiophen derivatives and polyaniline derivatives). In other words, the porous structure or the mesh structure contained in the conductive material layer 46a can include a metallic nanoparticle, a metallic nanowire, a nanoparticle of conductive oxide, a nanowire of conductive oxide, a nanoparticle of conductive polymer compound, or a nanowire of conductive polymer compound. The materials of the nanoparticle or metallic nanowire as the conductive material are preferably Ag and Cu, more preferably Ag.

From the viewpoint of easily forming the layer, the conductive material layer 46a preferably comprises porous structure. From the viewpoint of suppressing electric resistance, the conductive material layer 46a preferably comprises mesh structure.

The preferable thickness of electrode containing the getter material 46 is a varied thickness depending on the embodiment of transparent (translucent) or opaque electrode, and variations of materials and structures selected. When the opaque electrode is formed, the thickness of the conductive material layer 46a is preferably thicker from the viewpoint of suppressing electrical resistance, and is preferably 500 nm or larger and 30000 nm or smaller.

When the transparent (translucent) electrode is formed, increasing the light transmittance and suppressing the electrical resistance are needed. Thus, when the conductive material layer 46a comprises porous structure, the thickness of conductive material layer 46a is preferably 10 nm or larger and 500 nm or smaller, more preferably 50 nm or larger and 200 nm or smaller. When the conductive material layer 46a comprises mesh structure, the thickness of conductive material layer 46a is preferably thicker because the light transmittance is achieved by interstitial spaces of mesh structure. The thickness of conductive material layer 46a is preferably 100 nm or larger and 30000 nm or smaller, more preferably 200 nm or larger and 5000 nm or smaller. The lower limit of the thickness of the electrode containing the getter material 46 is not especially limited as far as it is larger than 0, and is generally 5 nm or larger.

At least a part of the getter material 46b is distributed in the conductive material layer 46a, and placed in the interstitial spaces 46aa. In other words, a part of the getter material 46b may not exist in the conductive material layer 46a.

Preferably, the getter material 46b is distributed substantially uniformly in the conductive material layer 46a.

Preferably, the conductive material layer 46a and the getter material 46b are integrally configured as the electrode containing the getter material 46. In other words, the getter material 46b is preferably deposited only within the conductive material layer 46a, for example, from the viewpoint of downsizing of the devices. Specific embodiments of the electrode containing the getter material 46 will be described below.

The getter material 46b has functions which is capable of reacting with the first harmful substance and/or the second harmful substance described below. Herein, the term "react" has meanings of physically absorbing and holding the first harmful substance on the electrode containing the getter material 46, or forming the harmless substance by chemical reactions. By the reactions, the harmful substance(s) generated from the layered structure comprising the pair of electrodes 40 and the active layer 50, and the harmful substances that come from out of the layered structure, that is, the inside of the encapsulation member (electrodes or near thereof), and outer side of the encapsulation member (the atmosphere) can be disappeared. Herein, the term "harmful substance" has a meaning of a substance that changes physically or chemically the components of the organic photoelectric conversion element (for examples, oxidation, degradation and melting), thereby decreasing the photovoltaic characteristics of the organic photoelectric conversion element. The term "harmless substance" has a meaning of a substance that substantially does not change physically or chemically the components of the organic photoelectric conversion element. With the provisos that "harmless substance" does not have an effect on the photovoltaic characteristics of the organic photoelectric conversion element, and does not change physically or chemically the components of the organic photoelectric conversion element, the harmless substance may be a substance which enhances the light transmittance of the electrode containing the getter material 46.

The getter material 46b may comprise one or more materials selected from the group consisting of Ca, Al, Ti, Ba, Zr, Mg, Si, C, In, V, Nb, Ta, derivatives thereof (for examples, organic metal materials containing one or more metallic elements selected from the group consisting of Ca, Al, Ti, Ba, Zr, Mg, Si, In, V, Nb and Ta), or a binary, ternary or multicomponent mixture comprising Ca, Al, Ti, Ba, Zr, Mg, Si, C, In, V, Nb and Ta.

Examples of the first harmful substance may include water, oxygen, and residual solvents contained in any one of the active layer, the interlayers and the conductive material layer or combinations thereof. Examples of the residual solvents may include unsaturated hydrocarbon solvents such as toluene, xylene, mesitylene, tetralin, decalin, bicyclohexyl, butylbenzene, sec-butylbenzene, tert-butylbenzene, methyl benzoate, butyl benzoate, 1,3,5-trimethylbenzene and 1,2,4-trimethylbenzene; halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane and bromocyclohexane; halogenated unsaturated hydrocarbon solvents such as chlorobenzene, dichrolobenzene and trichrolobenzene; ether solvents such as tetrahydrofuran and tetrahydropyran; saturated hydrocarbon solvents such as hexane and octane; glycol solvents such as ethylene glycol; and alcohol solvents such as methanol, ethanol and 2-propanol.

Examples of the getter material 46b which is capable of reacting with the residual solvents, in addition to water and oxygen, may include Ca, Al, Si and derivatives thereof (for example, organic metal compounds containing one or more metallic elements selected from the group consisting of Ca, Al and Si such as organic aluminum compounds). Herein, the getter material 46b may be used alone or in combination of two or more of them at any ratio.

When the electrode containing the getter material 46 is transparent or translucent, a substance which is capable of reacting with the first harmful substance or a combination of the first harmful substance and the second harmful substance, thereby enhancing the light transmittance of the electrode containing the getter material 46, and a material which forms the harmless substance can be used as the getter material 46b. Specifically, the getter material 46b is preferably Ca or an organic metal material (for example, an organic aluminum compound). The organic metal materials is preferably a metal alkoxide, more preferably a metal alkoxide containing one or more metallic elements selected from the group consisting of Ca, Al, Ti, Ba, Zr, Mg, Si and In, still more preferably a metal alkoxide containing one or more metallic elements selected from the group consisting of Al, Ti and Zr.

An alkoxy group of the metal alkoxide is preferably an alkoxy group having 1 to 10 carbon atoms. Examples of the alkoxy group may include an isopropoxy group and a butoxy group.

Examples of a commercially available organic metal compound may include a metal alkoxide such as titanium isopropoxide, aluminum isopropoxide, zirconium butoxide and zirconium isopropoxide.

For example, when Ca is used as the getter material 46b, a substance being harmless and enhancing the light transmittance (for example, Ca(OH)₂) is formed by reacting it with the first harmful substance (water or oxygen), and therefore, the light transmittance of the electrode containing the getter material 46 can be effectively enhanced.

The getter material 46b may be a material further reacting with the second harmful substance existing outside of the pair of electrodes 40. In other words, in addition to the first harmful substance, the getter material 46b may be a material which is capable of further reacting with the second harmful substance existing outside of the pair of electrodes 40, that is, outside of the layered structure 20. Examples of the second harmful substance may include water, oxygen, and a compound released from the sealant 74 such as a compound containing N, O or S, and derivative thereof. Specific examples thereof may include a nitrogenous compound such as an amine compound, and an organic phosphoric acid compound as outgas components. The first harmful substance and the second harmful substance in the organic photoelectric conversion element 10 may be the same or different from each other.

The electrode containing the getter material 46 may include other components in addition to the conductive material layer 46a and the getter material 46b as long as the object of the present invention is not significantly impaired. Examples of the other components may include a binder, a filler and an antioxidant. Examples of the binder for holding the getter material 46b may include a resin material, and the specific examples thereof may include: a trifluoropolyethylene, a polychlorotrifluoroethylene (PCTFE), a polyimide, a polycarbonate, a poly(ethylene terephthalate), an alicyclic polyolefin, and an ethylene-vinyl alcohol copolymer. The other component may be used alone or in combination of two or more of them at any ratio.

The organic photoelectric conversion element 10 may further comprise a buffer layer for improving the characteristics between the conductive material layer 46a and the getter material 46b. It is expected that the adhesion property between the conductive material layer 46a and the getter material 46b is improved, or the conductivity of the conductive material layer 46a is improved because the buffer layer is inserted between the conductive material layer 46a and the getter material 46b. Examples of materials for the buffer layer may include an oxide such as SiO₂, Al₂O₃, TiO₂, ZnO, MnO₃ and WO₃, an epoxy resin, and a polymer material such as PEDOT:PSS. The buffer layer is usable with the provisos that the effect of removal of the harmful substances by the getter material 46b does not decrease. The buffer layer can be provided so that at the most 95% of the capacity of the interstitial portion 46aa in the conductive material layer 46a may be filled.

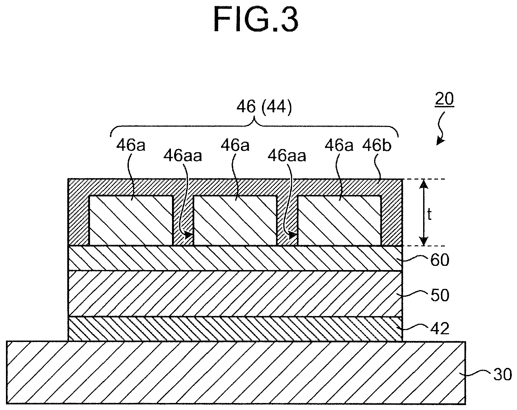

With reference to Figs. 2 and 3, examples of constitution regarding the embodiments of the electrode containing the getter material 46 will be described. In Figs. 2 and 3, the layered structure 20 provided on the substrate 30 is shown and detailed explanations of the constitutions without the electrode containing the getter material 46 will be omitted.

### (Embodiment 1)

Fig. 2 is a schematic cross-sectional view of the layered structure 20 of the Embodiment 1.

As illustrated in Fig. 2, in the electrode containing the getter material 46 of the Embodiment 1, the upper surface of the electrode containing the getter material 46 is covered by the getter material 46b. More specifically, the getter material 46b exists in the interstitial portion 46aa, and further covers the upper surface of the conductive material layer 46a.

The Embodiment 1 comprises an embodiment such that a distribution (density or concentration) of the getter material 46b in the thickness direction t of the electrode containing the getter material 46b is reduced toward the upper surface side (opening side of the interstitial portion 46aa) of the conductive material layer 46a, that is, the distribution of the getter material 46b is increased toward the interlayer 60 side of the conductive material layer 46a.

According to the Embodiment 1, it is effective in the case of being the first harmful substance in particular. Specifically, it is possible to easily react with the first harmful substance with the reduction of the amount used of the getter material 46b, and therefore, durability of the organic photoelectric conversion element can be effectively improved. According to the Embodiment 1, the amount used of the getter material 46b is able to be minimum amount, and thus the Embodiment 1 is preferable from the viewpoint of manufacturing cost.

### (Embodiment 2)

Fig. 3 is a schematic cross-sectional view of the element layered structure 20 of the Embodiment 2.

As illustrated in Fig. 3, according to the electrode containing the getter material 46 of the Embodiment 2, the getter material 46b covers the surface (upper surface and side surfaces) of the electrode containing the getter material 46. More specifically, the getter material 46b integrally covers the inside of the interstitial portion 46aa and the surface of the conductive material layer 46a.

According to the Embodiment 2, it is effective in the case of being both of the first harmful substance and the second harmful substance. Even though both of the first harmful substance and the second harmful substance exist, both of the first harmful substance and the second harmful substance can be effectively reacted with the getter material 46, and therefore, durability of the organic photoelectric conversion element can be effectively improved. According to the Embodiment 2, since the amount used of the getter material 46b is larger, this embodiment is more preferable when the amount of the harmful substances is larger or long term durability is required.

### <Method for forming the electrode containing the getter material>

The method for forming the electrode containing the getter material 46 (The method for manufacturing the organic photoelectric conversion element) comprising: a step of forming the conductive material layer 46a having interstitial spaces 46aa; and a step of forming an electrode containing the getter material 46 by applying the getter material 46b which is capable of reacting with the first harmful substance in at least a part of interstitial spaces 46aa of the conductive material layer 46a.

### (Step of forming the conductive material layer having interstitial spaces)

First, the conductive material layer 46a is formed. Examples of the method for forming the conductive material layer 46a may include a coating method, an evaporation method and a chemical vapor deposition method.

Examples of the method for forming the conductive material layer 46a having porous structure may include the method comprising: applying coating liquid containing nanoparticles or nanowires as a conductive material and a resin by using a coating method such as a spin coating method and removing the resin by drying and annealing obtained layer to form the conductive material layer 46a having interstitial spaces 46aa.

Examples of the method for forming the conductive material layer 46a having mesh structure may include a printing method, a vacuum deposition method using a mask. When the printing method is used, the conductive material layer 46a having interstitial spaces 46aa can be formed by arranging wirings containing nanoparticles or nanowires in a mesh form by using a coating liquid containing nanoparticles or nanowires as a conductive material and a resin, and removing the resin by drying and annealing obtained layer.

### (Step of forming the electrode containing the getter material)

Next, the getter material 46b which is capable of reacting with the first harmful substance is applied at least in the interstitial spaces 46aa of the conductive material layer 46a. The electrode containing the getter material 46 of the Embodiment 1 or 2 can be selectively formed by appropriately selecting the applying amount of the getter material 46b.

When the applying amount of the getter material 46b is smaller than the total capacity of the interstitial spaces 46aa, the electrode containing the getter material 46 of the Embodiment 1 can be obtained.

When the applying amount of the getter material 46b is larger than the total capacity of the interstitial spaces 46aa, the electrode containing the getter material 46 of the Embodiment 2 can be obtained. In other words, when the applying amount of the getter material 46b is larger than the total capacity of the interstitial spaces 46aa, the getter material layer 46b formed on the conductive material layer 46a can be formed.

The applying amount of the getter material 46b can be optimized by thickness B as an index in the case of forming the getter material layer 46b as a single layer in relation to the thickness A of the conductive material layer 46a. In other words, when the thickness A is larger than the thickness B (A>B), the electrode containing the getter material 46 of the Embodiment 1 can be obtained, and when the thickness A is equal to or smaller than the thickness B (A≤B), the electrode containing the getter material 46 of the Embodiment 2 can be obtained.

The getter material (the getter material layer) 46b may be applied (formed) by any suitable methods depending on the selected material. The getter material 46b can be applied by, for example, a sputtering method, a vacuum evaporation method, a chemical vapor deposition method, and a coating method using the coating liquid containing the getter material 46b.

The getter material 46b is preferably applied by the coating method because it is easy to treat and the cost can be reduced. From the viewpoint of increasing the durability of the organic photoelectric conversion element, the getter material 46b is preferably applied by the vacuum evaporation method. A large amount of the getter material 46b can be efficiently arranged in the interstitial spaces 46aa of the conductive material layer 46a because the solvent is not needed for the vacuum evaporation method.

As the coating liquid containing the getter material 46b, both of non-solvent type and solvent type can be used. Examples of the solvent for the solvent type coating liquid may include unsaturated hydrocarbon solvents such as toluene, xylene, mesitylene, tetralin, decalin, bicyclohexyl, butylbenzene, sec-butylbenzene, and tert-butylbenzene; halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane, and bromocyclohexane; halogenated unsaturated hydrocarbon solvents such as chlorobenzene, dichlorobenzene, and trichlorobenzene; and ether solvents such as tetrahydrofuran and tetrahydropyran; and alcohol solvents such as methanol, ethanol and 2-propanol. The solvents may be used alone or in combination of two or more of them at any ratio.

The amount of the solvent in the coating liquid containing the getter material 46b is generally more than or equal to 1000 parts by weight, preferably more than or equal to 5000 parts by weight, more preferably more than or equal to 10000 parts by weight, and is generally less than or equal to 20000 parts by weight, preferably less than or equal to 15000 parts by weight, more preferably less than or equal to 12000 parts by weight per 100 parts by weight of the getter material 46b.

Specifically, first, after preparing the coating liquid containing the getter material, the coating liquid is applied over the area where conductive material layer 46a is provided by a coating method such as a spin coating method, a casting method, a micro gravure coating method, a gravure coating method, a bar coating method, a roll coating method, a wire bar coating method, a dip coating method, a spray coating method, a screen printing method, a gravure printing method, a flexographic printing method, an offset printing method, an inkjet printing method, a dispenser printing method, a nozzle coating method, and a capillary coating method. Next, the electrode containing the getter material 46 can be formed by removing the solvent contained in the coating liquid by any preferable treatment such as heating or drying.

### [Active layer]

The active layer 50 is provided between the pair of electrodes 40. The active layer 50 comprises an organic compound, and the organic compound comprises a p-type semiconductor material as an electron-donor compound and an n-type semiconductor material as an electron-acceptor compound.

The active layer 50 may have a layered structure comprising two or more layers in which an electron-donor layer comprising an electron-donor compound and an electron-acceptor layer comprising an electron-acceptor compound are joined (p-n heterojunction type); or may have a single layer structure consisting of only one layer in which an electron-donor compound and an electron-acceptor compound are mixed (bulk hetero junction type).

Examples of the electron donor compound may include pyrazoline derivatives, arylamine derivatives, stilbene derivatives, triphenyldiamine derivatives, an oligothiophene and derivatives thereof, a polyvinylcarbazole and derivatives thereof, a polysilane and derivatives thereof, polysiloxane derivatives having aromatic amines in the main chain or side chains thereof, a polyaniline and derivatives thereof, a polypyrrole and derivatives thereof, a polyphenylenevinylene and derivatives thereof and a polythienylenevinylene and derivatives thereof.

Examples of the electron acceptor compound may include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, a diphenyldicyanoethylene and derivatives thereof, diphenoquinone derivatives, a metal complex of 8-hydroxyquinoline and derivatives thereof, a polyquinoline and derivatives thereof, a polyquinoxaline and derivatives thereof, a polyfluorene and derivatives thereof, carbon nanotubes, fullerenes and derivatives thereof. As the electron acceptor compound, carbon nanotubes, fullerenes, and fullerene derivatives are preferable.

Examples of the fullerenes may include C₆₀ fullerene, C₇₀ fullerene, C₇₆ fullerene, C₇₈ fullerene, and C₈₄ fullerene.

Examples of the fullerene derivatives may include derivatives of C₆₀ fullerene, C₇₀ fullerene, C₇₆ fullerene, C₇₈ fullerene, and C₈₄ fullerene. Specific examples of the fullerene derivatives may include compounds having the following structures:

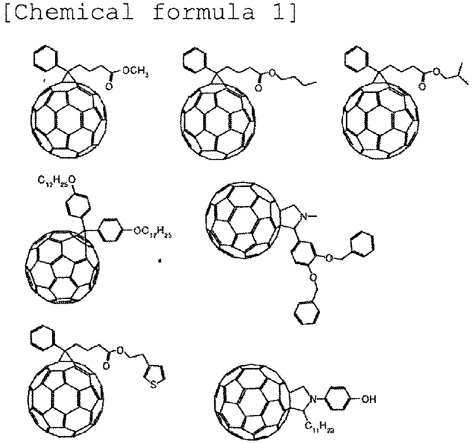

When the fullerene derivatives are used as the electron acceptor compound, the amount of the fullerene derivative is preferably 10 parts by weight to 1000 parts by weight, and more preferably 20 parts by weight to 500 parts by weight per 100 parts by weight of the electron donor compound.

The thickness of the active layer 50 is preferably 1 nm to 100 nm, more preferably 2 nm to 100 nm, still more preferably 5 nm to 500 nm, and particularly preferably 20 nm to 200 nm.

### <Method for forming the active layer>

As a method for forming the active layer 50, a wide variety of thin film formation methods may be adopted according to the material of the active layer. Examples of the method for forming the active layer 50 may include a coating method using a solution or a dispersion containing soluble materials such as a polymer compound as the coating liquid, and vacuum evaporation method can be used when materials having a lower boiling point such as small molecular weight compounds are adopted.

A solvent used for the coating liquid is selected depending on types of a material containing in the active layer. As solvents, water or an organic solvent can be used. Examples of the organic solvents may include: unsaturated hydrocarbon solvents such as toluene, xylene, mesitylene, tetralin, decalin, bicyclohexyl, butylbenzene, sec-butylbenzene, and tert-butylbenzene, methyl benzoate, butyl benzoate, 1,3,5-trimethylbenzene, and 1,2,4-trimethylbenzene; halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane, and bromocyclohexane; halogenated unsaturated hydrocarbon solvents such as chlorobenzene, dichlorobenzene, and trichlorobenzene; and ether solvents such as tetrahydrofuran and tetrahydropyran.

Examples of the coating method in which coating liquid (that is, a liquid substance such as an ink) is used may include a spin coating method, a casting method, a micro gravure coating method, a gravure coating method, a bar coating method, a roll coating method, a wire bar coating method, a dip coating method, a spray coating method, a screen printing method, a gravure printing method, a flexographic printing method, an offset printing method, an inkjet printing method, a dispenser printing method, a nozzle coating method, and a capillary coating method. Especially, the spin coating method, the flexographic printing method, the gravure coating method, the inkjet printing method and the dispenser printing method are preferable.

When the bulk heterojunction type active layer is formed as the active layer 50, as mentioned above, the coating methods using the coating liquid is adopted. As one embodiment for forming the bulk heterojunction active layer, a coating method wherein a mixed liquid comprising two types semiconductor materials and solvents is prepared as a coating liquid and using the mixed liquid, in which one of the two types semiconductor materials is a p-type organic semiconductor material and the other is a n-type semiconductor material, is carried out.

### [Encapsulation member]

The organic photoelectric conversion element 10 comprises the encapsulation member 70. Examples of encapsulation member 70 may include the combination of cover glass 72 having concave portion and the sealant 74 as explained in the above description referring to Fig. 1.

The encapsulation member 70 may be a layered structure consisting of one or more layers. Therefore, Examples of the encapsulation member 70 may further include a gas barrier layer and a film having gas barrier characteristics as a layer structure.

The layered structure as the encapsulation member 70 is preferably formed from a material having characteristics of blocking water (water vapor barrier characteristics) or characteristics of blocking oxygen (oxygen barrier characteristics). Preferred examples of the material for the layered structure may include organic materials including resins such as a trifluoropolyethylene, a polychlorotrifluoroethylene (PCTFE), a polyimide, a polycarbonate, a poly(ethylene terephthalate), an alicyclic polyolefin, and an ethylene-vinyl alcohol copolymer; and inorganic materials such as silicon oxide, silicon nitride, aluminum oxide, and diamond-like carbon.

The layered structure can be formed by any method depending on the material type thereof. Examples of the forming method may include a gas phase film formation method, a spin coating method, a dipping method, and a spray method. Moreover, a previously formed film may be bonded with a sealant (an adhesive).

### [Interlayer]

The organic photoelectric conversion element 10 may comprise an interlayer 60 between the first electrode 42 and the active layer 50 and/or between the second electrode 44 and the active layer 50.

The interlayer 60 is a layer which is capable of transporting the charge generated in the active layer 50 to the electrode. The interlayer 60 between the first electrode 42 and the active layer 50 transports the charge generated in the active layer 50 to the first electrode 42, while the interlayer 60 between the second electrode 44 and the active layer 50 transports the charge generated in the active layer 50 to the second electrode 44.

The interlayer 60 provided between the active layer 50 and an anode is a layer which is capable of transporting holes generated in the active layer 50 to the anode, and is also called a hole transport layer or an electron block layer. The interlayer 60 provided between the active layer 50 and a cathode is a layer which is capable of transporting electrons generated in the active layer 50 to the cathode, and is also called an electron transport layer or a hole block layer. The organic photoelectric conversion element 10 comprising the interlayer 60 can increase extraction efficiency of the hole generated in the active layer 50 to the anode. Moreover, the organic photoelectric conversion element 10 comprising the interlayer 60 can increase extraction efficiency of the electron generated in the active layer 50 to the cathode. Further, the organic photoelectric conversion element 10 comprising the interlayer 60 can suppress transfer of the hole generated in the active layer 50 to the cathode. In addition, the organic photoelectric conversion element 10 comprising the interlayer 60 can suppress transfer of the electron generated in the active layer 10 to the anode. Consequently, the photovoltaic conversion efficiency can be improved.

The interlayer 60 may comprise a material which is capable of transporting charge generated in the active layer 50 and/or reducing interface barrier (adjusting energy level). Especially, the interlayer 60 (hole transport layer or electron blocking layer) provided between the active layer 50 and the anode preferably comprises a material which is capable of transporting the hole and suppressing the transfer of the electron to the interlayer 60. The interlayer 60 (electron transport layer or hole blocking layer) provided between the active layer 50 and the cathode preferably comprises a material which is capable of transporting the electron and suppressing the transfer of the hole to the interlayer 60.

Examples of the material for the interlayer 60 may include: a halide and an oxide of an alkali metal or an alkaline earth metal such as lithium fluoride; an inorganic semiconductor such as zinc oxide, titanium oxide, titanium dioxide; bathocuproine, bathophenanthroline and derivatives thereof; triazole compound; tris(8-hydroxyquinolinate) aluminum complex; bis(4-methyl-8-quinolinate) aluminum complex; an oxadiazole compound; distyrylarylene derivatives; silole compound; 2,2',2"-(1,3,5-benzenetolyl)-tris-[1-phenyl-1H-benzimidazole] (TPBI) phthalocyanine derivatives; naphthalocyanine derivatives; porphyrin derivatives; aromatic diamine compound such as N,N'-bis(3-methylphenyl)-(1,1'-biphenyl)-4,4'-diamine (TPD) and 4,4'-bis[N-(naphthyl)-N-phenyl-amino]biphenyl (α-NPD); oxazole; oxadiazole; triazole; imidazole; imidazolone; stilbene derivatives; pyrazoline derivatives; tetrahydroimidazole; a polyarylalkane; butadiene; 4,4',4"-tris(N-(3-methylphenyl)-N-phenylamino)triphenylamine (m-MTDATA), a polyethyleneimine and derivatives thereof; a polyvinylcarbazole; a polysilane; a polyaniline and derivatives thereof, a polythiophene and derivatives thereof such as a poly(3,4-ethylenedioxythiophene) (PEDOT). When the interlayer 60 is the hole transport layer or the electron blocking layer, poly(3,4-ethylenedioxythiophene) (PEDOT) is preferably used as the material of the interlayer 60. When the interlayer 60 is the electron transport layer or the hole blocking layer, zinc oxide or polyethyleneimine is preferably used as the material of the interlayer 60.

The interlayer 60 has a thickness of generally 0.1 nm or larger, preferably 0.5 nm or larger, and more preferably 1 nm or larger, and has a thickness of generally 1,000 nm or smaller, preferably 500 nm or smaller, and more preferably 100 nm or smaller. The thickness of the interlayer 60 is preferably 0.1 nm or larger, for exerting the functions of the organic photoelectric conversion element 10, and the thickness is preferably 1,000 nm or smaller from the viewpoint of decreasing the thickness of the organic photoelectric conversion element 10.

### <Method for forming the interlayer>

The interlayer 60 is preferably formed by the coating method applying the coating liquid comprising the material for the interlayer 60 onto a predetermined area because it is easy to form and the cost for forming can be reduced. The solvents for the coating liquid are selected depending on the materials containing in the interlayer 60. Herein, when the interlayer 60 is formed so as to be in contact with the active layer 50 after forming the active layer 50, the solvents which do not dissolve the active layer 50 are selected. The coating methods for forming the interlayer 60 are the same methods used for forming the active layer 50.

### [Application of the organic photoelectric conversion element]

The organic photoelectric conversion element 10 may be used, for example, as a solar cell. When the organic photoelectric conversion element 10 is used as the solar cell, the organic photoelectric conversion element 10 is generally used as the solar cell. The plurality of solar cells may also be integrated to make the organic thin film solar cell module to be used as an embodiment of the solar cell module. The organic photoelectric conversion element 10 has long lifetime; therefore, the solar cell module comprising the organic photoelectric conversion element 10 can be expected to have longer lifetime.

Known examples of the structure of the solar cell module may include module structures such as a superstrate type, a substrate type, and a potting type; and a substrate-integrated module structure used in an amorphous silicon solar cell. As the solar cell module using the organic photoelectric conversion element 10, a suitable module structure may be appropriately selected depending on an intended purpose, place, environment, and the like.

The organic photoelectric conversion element 10 can also be used as an organic optical sensor. For example, when the organic photoelectric conversion element 10 is irradiated with light while applying electrical voltage between the electrodes or not applying it, charges are generated. Hence, when the charges are detected as a photocurrent, the organic photoelectric conversion element 10 can serve as the organic optical sensor. The plurality of organic optical sensors may be integrated to be used as an organic image sensor.

### EXAMPLES

The following describes the present invention in more detail with reference to examples. The present invention is not limited to the following examples.

### <Example 1>

A substrate with ITO film having a thickness of 150 nm were washed with acetone and isopropyl alcohol (IPA), and treated by UV-ozone (manufactured by Technovision, Inc.; UV-312) for 15 minutes. Polyethylene imine of which 80 % was ethoxylated (PEIE) (manufactured by Aldrich, Mw: 70000 g/mol aqueous solution (concentration 35∼40%)) was further diluted with distilled water to weight concentration of 0.4 %. For forming the interlayer (electron transport layer), the obtained solution was spin coated onto ITO film. Then the formed PEIE layer was baked at 120 °C for 10 minutes in the air.

For forming the active layer, a methyl benzoate/1,2,4-trimethylbenzene solution containing p-type semiconductor material A (refer to WO 2013/051676) in an amount of 0.52 wt% respect to the solvent and n-type semiconductor material C60PCBM (product name Nanomspectra E100, manufactured by Frontier Carbon Ltd Company) in an amount of 1.04 wt% respect to the solvent was stirred at 85 °C for 3 hour, then cooled to 25 °C. The obtained solution was coated onto the PEIE layer by spin coating to obtain a layer having a thickness of 160 nm. The active layer was obtained by baking the obtained layer at 150 °C for 5 minutes.

Next, for forming the interlayer (hole transport layer), polythiophene derivative (product name AQ1300, manufactured by Solvey) was spin coated onto the active layer to obtain a layer having a thickness of 50 nm and the obtained layer was annealed at 70°C for 2 minutes in the air to obtain the hole transport layer.

Ag Nanowire (AgNw) (product name Clear Ohm Ink N, manufactured by Cambrios Technologies.Corp.) was coated by spin coating onto the obtained hole transport layer to obtain AgNw layer having a thickness of 120 nm. Next, after annealing at 70°C for 2 minutes, Ca (getter material) was evaporated onto the obtained AgNw layer (conductive material layer) to obtain the completed sample. The applying amount of Ca was less than the total capacity of the interstitial portion in the Ag nanowire layer.

All degrees of vacuum during evaporation were 1x10⁻⁴ Pa to 9x10⁻⁴ Pa, and Ca was evaporated so that the layer could have a thickness of 30 nm to obtain the element layered structure having the same as those of the embodiment 1 as above described.

The obtained element layered structure was then encapsulated using a cover glass and a UV curing adhesive (manufactured by Nagase chemtex, product name XNR-5516Z) under inert gas atmosphere to obtain the organic photoelectric conversion element.

The obtained organic photoelectric conversion element (active area 1 cm²) was evaluated by using a solar simulator (manufactured by Bunkou-Keiki, product name OTENTO-SUN II) and irradiating with light of an irradiance of 100 mW/cm² through AM1.5G filter, and then the power generation was confirmed by measuring the generated current and voltage.

Durability of the obtained organic photoelectric conversion element was investigated by using the weathering test apparatus ATLAS (product name Ci4000, manufactured by ATLAS Co.) and operating it under the conditions: irradiance of 60 W/m² (wave length 300-400 nm), black panel temperature of 63 °C, relative humidity of 50 %RH. Durability was evaluated by recording the initial photoelectric conversion efficiency, the photoelectric conversion efficiency after 100 hours and after 995 hours from the start of the test and reported a ratio of photoelectric conversion efficiency at 100 hours and 995 hours to initial photoelectric conversion efficiency, respectively. The results are shown in Table 1 below.

### <Example 2>

The organic photoelectric conversion element of the Example 2 was manufactured in the same manner as the Example 1 except for forming the electrode containing the getter material by coating method as follows. Specifically, a liquid form titanium isopropoxide (manufactured by Aldrich) was used as a coating liquid, and the coating liquid was applied onto the Ag nanowire layer (conductive material layer) made by the same manner as the Example 1 to obtain the electrode containing the getter material. The applying amount of the coating liquid was more than the total capacity of the interstitial portion in the Ag nanowire layer, and as a result, the coating liquid integrally covered inside of the interstitial spaces in the Ag nanowire layer and the surface of the Ag nanowire layer, and the upper surface of the electrode containing the getter material had flat surface. Next, durability of the encapsulated sample after 100 hours from the start of the test was evaluated in the same manner as the Example 1.

### <Example 3>

The organic photoelectric conversion element of the Example 3 was manufactured in the same manner as the Example 1 except for forming the electrode containing the getter material by coating method as follows. Specifically, a liquid form aluminum isopropoxide (manufactured by Aldrich) was used as the coating liquid containing getter material, and the coating liquid was applied onto the Ag nanowire layer (conductive material layer) made by the same manner as the Example 1 to obtain the electrode containing the getter material. The applying amount of the coating liquid was more than the total capacity of the interstitial portion in the Ag nanowire layer, and as a result, the coating liquid integrally covered inside of the interstitial spaces in the Ag nanowire layer and the surface of the Ag nanowire layer, and the upper surface of the electrode containing the getter material had flat surface. Next, durability of the encapsulated sample after 100 hours from the start of the test was evaluated in the same manner as the Example 1.

### <Example 4>

The organic photoelectric conversion element of the Example 4 was manufactured in the same manner as the Example 1 except for forming the electrode containing the getter material by coating method as follows. Specifically, a liquid form zirconium butoxide (manufactured by Aldrich) was used as the coating liquid, and the coating liquid was applied onto the Ag nanowire layer (conductive material layer) made by the same manner as the Example 1 to obtain the electrode containing the getter material. The applying amount of the coating liquid was more than the total capacity of the interstitial portion in the Ag nanowire layer, and as a result, the coating liquid integrally covered inside of the interstitial spaces in the Ag nanowire layer and the surface of the Ag nanowire layer, and the upper surface of the electrode containing the getter material had flat surface. Next, durability of the encapsulated sample after 100 hours from the start of the test was evaluated in the same manner as the Example 1.

### <Comparative Example 1>

The organic photoelectric conversion element was manufactured and evaluated in the same manner as the Example 1 except for depositing no Ca onto the Ag nanowire layer, using a cover glass wherein a water getter sheet (product name HDS, manufactured by Dynic ltd) was added to the interior side of the cover glass, and encapsulating under inert gas atmosphere.

### <Comparative Example 2>

The organic photoelectric conversion element was manufactured and evaluated in the same manner as the Comparative Example 1 except for using the cover glass without the getter sheet and encapsulating under inert gas atmosphere.

### <Comparative Example 3>

The organic photoelectric conversion element was manufactured and evaluated in the same manner as the Comparative Example 1 except that, instead of the Ag nanowire layer, Ag layer having the thickness of 60 nm was evaporated in a vacuum evaporation apparatus. All degrees of vacuum during evaporation were 1X10⁻⁴ Pa to 9x10⁻⁴ Pa.

**[Table 1]**

| | Electrode material | Getter material/ Position | Durability (After 100 hours) | Durability (After 995 hours) |
|---|---|---|---|---|
| Example 1 | Ag nanowire | Ca(deposition) /in Ag nanowires | 0.99 | 0.90 |
| Example 2 | Ag nanowire | Titanium isopropoxide/ in Ag nanowires | 0.99 | |
| Example 3 | Ag nanowire | Aluminum isopropoxide/ in Ag nanowires | 0.99 | |
| Example 4 | Ag nanowire | Zirconium butoxide/ in Ag nanowires | 0.87 | |
| Comparative Example 1 | Ag nanowire | HD-S(sheet adhesion)/ on the interior side of the cover glass | 0.83 | 0.80 |
| Comparative Example 2 | Ag nanowire | None | 0.81 | 0.72 |
| Comparative Example 3 | Ag (deposition) | HD-S(sheet adhesion)/ on the interior side of the cover glass | 0.74 | 0.51 |

As shown in Table 1, the organic photoelectric conversion elements of the Examples 1-4 having the electrode containing a getter material 46 wherein the getter material 46b was contained in at least the part of the interstitial portion 46aa in the conductive material layer 46a was adopted showed better durability than the Comparative Examples 1-3 after 100 hours from the start of the test. Especially, the organic photoelectric conversion element of the Examples 1-3 showed little deterioration after 100 hours from the start of the test, and excellent durability. The organic photoelectric conversion element of the Example 1 showed better durability than the Comparative Examples 1-3 after 995 hours from the start of the test.

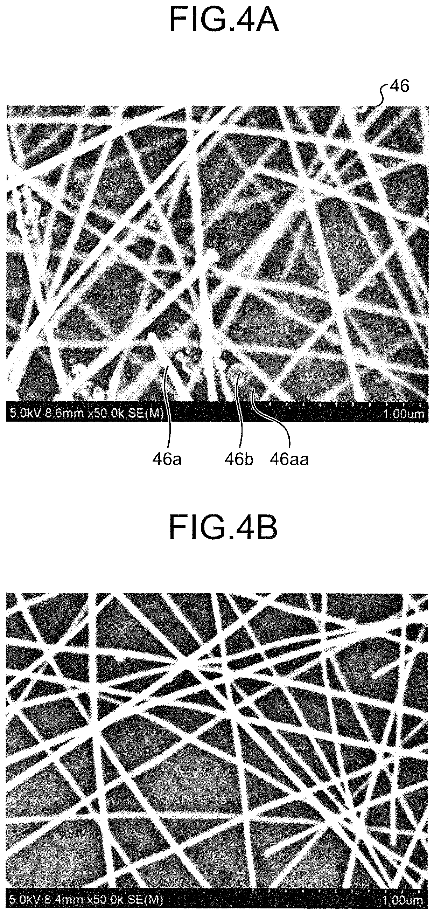

Fig. 4A is a SEM image of the electrode containing the getter material of the Example 1, and Fig. 4B is a SEM image of the electrode of the Comparative Example 2, which were obtained by using S-4000 (product name, manufactured by HITACHI high technologies) and imaging conditions of a scale factor of 50 K and of an accelerating voltage of 5 kV.

As shown in Fig. 4A, Ca serving as the getter material 46b was distributed in the conductive material layer 46a, and arranged in the interstitial spaces 46aa.

Ca serving as the getter material 46b reacts with water and/or oxygen to generate harmless compounds. Such reactivity gives benefits to the improvement of the transmission of the electrode in the visible range.

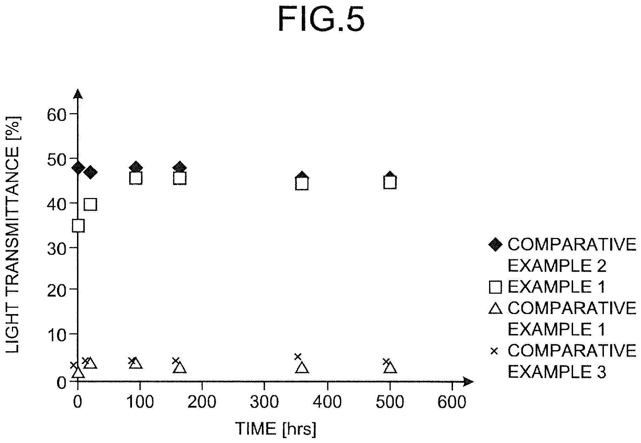

Fig. 5 is a graph illustrating characteristics of the light transmittance of the photoelectric conversion element. As shown in Fig. 5, according to the organic photoelectric conversion element of the Example 1, a remarkably excellent light transmittance is achieved as compared to the Comparative Examples 1 and 3 using the getter sheet. That is, according to the constitution of the Example 1, both of higher durability and light transmittance of the organic photoelectric conversion element can be satisfied.

### EXPLANATIONS OF LETTERS OR NUMERALS

- 10: Organic photoelectric conversion element
- 20: Element layered structure
- 30: Substrate
- 40: Electrode
- 42: First electrode
- 44: Second electrode
- 46: Electrode containing a getter material
- 46a: Conductive material layer (Permeable electrode)
- 46aa: Interstitial portion (Porous portion)
- 46b: Getter material (Getter material layer)
- 50: Active layer
- 60: Interlayer
- 70: Encapsulation member
- 72: Cover glass
- 74: Sealant

## Claims

1. An organic photoelectric conversion element comprising:
a layered structure comprising a pair of electrodes comprising a first electrode and a second electrode; and
an active layer provided between the pair of electrodes,
wherein,
at least one electrode of the pair of electrodes comprise an electrode containing a getter material comprising an conductive material layer having interstitial spaces which a first harmful substance contained in the layered structure permeates and at least one kind of the getter material which is capable of reacting with the first harmful substance, and
the getter material is contained in at least a part of the interstitial spaces.

2. The organic photoelectric conversion element according to claim 1, wherein the getter material is a material further reacting with a second harmful substance out of the layered structure.

3. The organic photoelectric conversion element according to claim 1 or 2, wherein the getter material is distributed in the conductive material layer, and placed in the interstitial spaces.

4. The organic photoelectric conversion element according to any one of claims 1 to 3, wherein the surface of the electrode containing the getter material is covered with the getter material.

5. The organic photoelectric conversion element according to any one of claims 1 to 4, further comprising an interlayer provided between the electrode containing the getter material and the active layer.

6. The organic photoelectric conversion element according to any one of claims 1 to 5, wherein the getter material is a material reacting with the first harmful substance, or a combination of the first harmful substance and the second harmful substance to form a harmless substance.

7. The organic photoelectric conversion element according to claim 6, wherein the getter material comprises one or more materials selected from the group consisting of Ca, Al, Ti, Ba, Zr, Mg, Si, C, In, V, Nb and Ta.

8. The organic photoelectric conversion element according to claim 6, wherein the getter material comprises an organic metal compound containing one or more metallic elements selected from the group consisting of Ca, Al, Ti, Ba, Zr, Mg, Si, In, V, Nb and Ta.

9. The organic photoelectric conversion element according to claim 8, wherein the organic metal compound is a metal alkoxide.

10. The organic photoelectric conversion element according to claim 9, wherein the metal alkoxide contains one or more metallic elements selected from the group consisting of Ca, Al, Ti, Ba, Zr, Mg, Si and In.

11. The organic photoelectric conversion element according to claim 6, wherein the getter material is a material reacting with the first harmful substance or a combination of the first harmful substance and the second harmful substance to form a substance enhancing a light transmittance of the electrode containing the getter material.

12. The organic photoelectric conversion element according to claim 11, wherein the getter material comprises Ca.

13. The organic photoelectric conversion element according to any one of claims 1 to 12, wherein the conductive material layer has porous structure or mesh structure containing nanoparticles or nanowires as a conductive material.

14. The organic photoelectric conversion element according to claim 13, wherein the nanowires are metallic nanowires.

15. A method for manufacturing the organic photoelectric conversion element according to any one of claims 1 to 14 comprising:
a step of forming the conductive material layer having interstitial spaces; and
a step of forming the electrode containing the getter material by applying the getter material which is capable of reacting with the first harmful substance at least a part of interstitial spaces of the conductive material layer.

16. The method for manufacturing the organic photoelectric conversion element according to claim 15, wherein the step of forming the electrode containing the getter material is a step of applying the getter material in the interstitial spaces by an evaporating method or an coating method.
